# EUROPEAN PATENT SPECIFICATION

(11) **EP 2 107 620 B1**
(45) Date of publication and mention of the grant of the patent: **29.07.2015**
(21) Application number: 09156441.9
(22) Date of filing: 27.03.2009
(51) Int. Cl.: H01L 33/00, H01L 33/64, H01L 33/60

(54) **Light emitting device with LED chip**
Lichtquelle mit Leuchtdiodenchip
Source de lumière avec puce LED

(30) Priority: 27.03.2008 TW 97111139
(43) Date of publication of application: 07.10.2009
(73) Proprietor: Liung Feng Industrial Co Ltd, Taipei Hsien (TW)
(72) Inventor: Hsu, Tsang-lin, Taipei Hsien (TW); Lin, Heng-I, Taipei Hsien (TW)
(74) Representative: Viering, Jentschura & Partner Patent- und Rechtsanwälte

(56) References cited:
- WO-A-2006/046981
- US-A1- 2004 135 166
- US-A1- 2007 121 327
- US-A1- 2007 252 157

## Description

### BACKGROUND OF THE INVENTION

### 1. FIELD OF THE INVENTION

The present invention relates to a light emitting device and a method for manufacturing the same, and particularly to a light emitting device having a light emitting diode (LED) chip component and a heat sink substrate, and as well as a method for manufacturing the same

### 2. RELATED ART

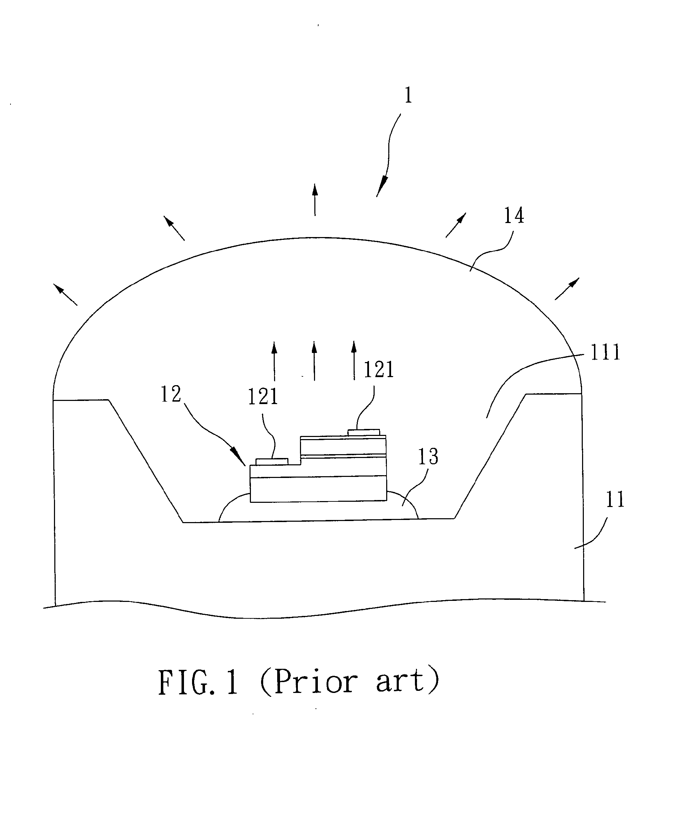

As shown in Fig. 1, a conventional LED light emitter 1, in general, includes a heat sink 11 having a recess 111 for dissipating heat, an LED chip 12 provided in the recess 111 for emitting light by photoemission, a connecting portion 13 (using the conducting paste, but the thermal conductivity coefficient of the paste is low) between a bottom of the recess 111 and the LED chip 12 for gluing the LED chip 12, and a transparent stuffing portion 14 stuffing the recess 111 for isolating the LED chip 12.

As shown in Fig. 1, a conventional LED light emitter 1, in general, comprises a heat sink 11 having a recess 111 for dissipating heat, an LED chip 12 provided in the recess 111 for emitting light by photoemission, a connecting portion 13 (using the conducting paste, but the thermal conductivity coefficient of the paste is low) between a bottom of the recess 111 and the LED chip 12 for gluing the LED chip 12, and a transparent stuffing portion 14 stuffing the recess 111 for isolating the LED chip 12.

The light emitter 1 is manufactured as follows. An LED chip 12 is provided firstly. The LED chip 12 and the connecting portion 13 are glued to the recess 111 of the heat sink holder11. The stuffing portion 14 is filled in the recess 111.

The light emitter 1 is basically able to meet contemporary need. Its manufacture process is able to come into reality thanks to long-term semiconductor manufacturing and packaging, as well. But people are still endeavor to study and improve the light emitter 1. Such designs are shown in Taiwan Patent Nos. 095104637 and 095106043. The patent No. 095104637 discloses an insulted base between a substrate and a connecting portion for enhancing light luminance. The patent No. 095106043 discloses a static discharge prevention element packaged in an LED and a method for manufacturing it.

However, the conventional light emitter 1 includes an LED chip 12 glued by a connecting portion 13. Thermal conduction is subject to different thermal conduction coefficients of different layers and interfaces, and influences light emission and lifespan of the light emitter 1. On the other hand, during the connecting portion 13 is glued to the LED chip 12, the connecting portion 13 is apt to form voids because of piling and pressing, thus destroying interface of thermal conduction, seriously influencing heat dissipation of the light emitter 1, and shortening its life.

WIPO patent application No. WO2006112356A1 and Japanese patent application No. JP2006339542A both disclose a die directly bonded on a thermal circuit board for heat dissipation. However, this method requires material good at heat dissipation. Moreover, thermal size is just the contact size of the die, obstructing reduction of thermal resistance. US patent application No. US2007/0252157A1 discloses a light emitting apparatus, which includes a substrate, a first metal layer, an insulating layer and at least one light emitting device. The heat generated by the light emitting device can be dissipated through the substrate or the first metal layer. The light emitting apparatus processes the first metal layer with superior thermal conductivity, such that it is possible to enhance the heat dissipating efficiency and avoid the thermal conductive adhesive. The insulating layer disposed on the first metal layer has a patterned area for exposing at least a portion of the first metal layer. The light emitting device is located with the patterned area and is directly disposed on the first metal layer.

In addition, to make the LED light emitter emit, electrodes disposed on the LED chip have to be electrically connected to external circuits. Therefore, before packaging the LED light emitter the electrodes of the LED chip must be preformed with connecting points for connecting with the external circuits; however, such process of preforming the connecting points complicates the packaging method and obstacle development of the package.

Document US2007/0121327 A1 teaches a method of manufacturing a LED chip component, comprising mounting an LED chip embedded in an adhesive tape onto a mounting surface of a temporary carrier substrate in such a way that a light emitting plane of the LED chip is facing the mounting surface of the temporary carrier substrate, thereby forming an adhesive tape layer on the mounting surface of the temporary carrier substrate, the adhesive tape surrounding peripheral surfaces of the LED chip, depositing a metal film reflector on and conforming to the exposed surfaces of the adhesive tape and of the LED chip protruding from the adhesive tape, forming a heat sink substrate by depositing a high thermal conductivtiy material on the metal film reflector, before removing the adhesive tape and the temporary carrier substrate.

### SUMMARY OF THE INVENTION

Accordingly, a main object of the present invention is to provide a method for manufacturing a LED chip component having a heat sink substrate, which enhance thermal dissipation of a LED chip thereof and which improves light emission of the LED chip and lengthens life thereof.

Another object of the present invention is to provide a packaging method for packaging the LED chip component having the heat sink substrate, wherein electrodes of the LED chip are connected with electrodes of the heat sink substrate without connecting with external circuits and preforming connecting points of the LED chip, so that to simplify packaging procedure and reduce manufacturing cost and enhance production efficiency.

According to an example, to achieve the above objects, the LED chip component includes a heat sink substrate and at least a LED chip, wherein the heat sink substrate is made of material with high thermal conductivity coefficient, and including a reflecting mirror having a central portion and a reflecting portion surrounding the central portion, a normal of a top surface of the reflecting portion forming an acute angle relative to a normal of a top surface of the central portion.

According to the above-mentioned LED chip component, the LED chip is unitarily connected with a top surface of the central portion of the reflecting mirror, and including a base material connecting with the top surface of the central portion, a light emitting film on the holder for emitting light by photoemission, and an electrode unit connecting with and Ohmic contacting the light emitting film for supplying power for the light emitting film.

The current invention provides a method for manufacturing a LED chip component according to claim 1, the method including: a chip setting step, a sacrificial layer forming step, a heat sink substrate forming step, and a sacrificial layer removing step, wherein the chip setting step provides a LED chip including a base material, a light emitting film on the base material for generating light by photoemission, and an electrode unit connecting with and Ohmic contacting the light emitting film for supplying power for the light emitting film;

The sacrificial layer forming step is performed by forming a removable sacrificial layer surrounding a peripheral of the LED chip from a top of the LED chip to the support portion such that the sacrificial layer decreases in thickness.

The heat sink substrate forming step performed by forming a heat sink substrate from a bottom of the LED chip to the sacrificial layer with material of high thermal conductivity coefficient such that a top surface of the heat sink substrate is substantially parallel to a bottom surface of the base material.

The sacrificial layer removing step performed by removing the sacrificial layer to form the LED chip component with heat sink substrate.

According to the present invention, the method for manufacturing the LED chip component further includes a packaging method which includes an electrode forming step, a connecting step, and a bonding step, wherein the electrode forming step defined by providing a carrier formed with an anode and a cathode, the connecting step performed by electrically connecting the anode and the cathode of the carrier with the electrode unit of the LED chip, and the bonding step defined to further bond the carrier with the LED chip firmly.

### BRIEF DESCRIPTION OF THE DRAWINGS

Fig. 1 is a schematic cross-sectional view of a conventional light emitting device of LED chip;
Fig. 2 is a schematic cross-sectional view of a LED chip component fabricated acccording to an embodiment of the method of the current invention, the component having a heat sink substrate;
Fig. 3 is a flow chart of a method for manufacturing the LED chip component of Fig. 2;
Fig. 4 is a schematic cross-sectional view illustrating a semi-manufactured product of the LED chip component formed by a chip setting step of the method of Fig. 3;
Fig. 5 is a schematic cross-sectional view illustrating the semi-manufactured of the LED chip component further formed by a sacrificial layer forming step of the method of Fig. 3;
Fig. 6 is a schematic cross-sectional view illustrating the semi-manufactured of the LED chip component further formed by a heat sink substrate forming step of the method of Fig. 3;
Fig. 7 is a schematic cross-sectional view showing the LED chip component having a heat sink substrate fabricated according to a second embodiment of the present invention;
Fig. 8 is a flowchart of a method for packaging the LED chip component of the present invention;
Figs. 9A to 9F show a first variant of the method for packaging an LED chip;
Figs. 10A to 10F show a second variant of the method for packaging the LED chip component;
Figs. 11A to 11D show a third variant of the method for packaging the LED chip component;
Fig. 12 show a fourth variant of the method for packaging the LED chip component; and
Figs. 13A and 13B respectively illustrate a fifth and a sixth variant of the method for packaging the LED chip component.

### DESCRIPTION OF THE PREFERRED EMBODIMENTS

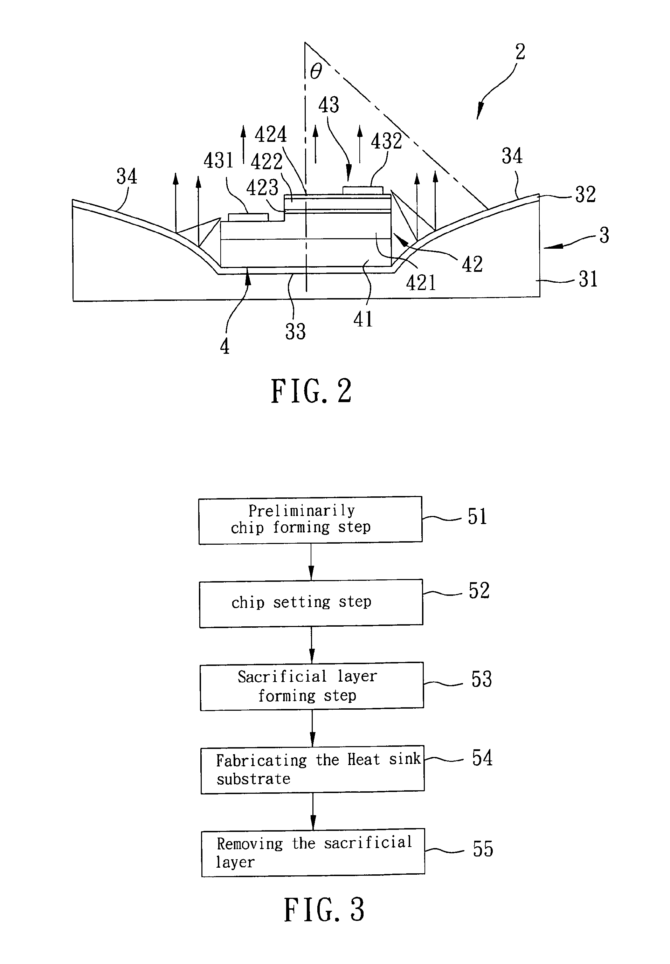

Referring to Fig. 2, a light emitting device having a LED chip component with a heat sink substrate 2 in accordance with a first embodiment of the present invention includes a heat sink substrate 3 and at least a light emitting diode (LED) chip 4 disposed on the heat sink substrate 3. In this embodiment, only one LED chip 4 is provided, and the LED chip 4 is, for instance, a horizontal conductive LED chip.

The heat sink substrate 3 is made of high thermal conductivity coefficient material, and has a base 31 formed of either one of copper, gold, silver, nickel, tin, titanium, platinum, palladium, tungsten, molybdenum and etc., or an alloy with elements selected from the above-mentioned materials. A reflecting mirror 32 is made of high reflective coefficient material and disposed on the base 31. The reflecting mirror 32 includes a central portion 33 and a reflecting portion 34 surrounding the central portion 33. The LED chip 4 is integrally formed on the central portion 33. The normal of a top surface of the reflecting portion 34 forms an acute angle with respect to the normal of a top surface of the central portion 33. The top surface of the reflecting portion 34 is a smooth curved surface and substantially protrudes reverse to a bottom of the heat sink substrate 3, whereby light is reflected for concentrative emission.

The LED chip 4 is unitarily connected with the heat sink substrate 3. The LED chip 4 has a base material 41 connecting with the top surface of the central portion 33, a light emitting film 42 for emitting light by photoemission, and an electrode unit 43 connecting with and Ohm contacting the light emitting film 42 for supplying power for the light emitting film 42. The light emitting film 42 includes a first coating layer 421 and a second coating layer 422 respectively doped to form different n-type or p-type, an active layer 423 between the first coating layer 421 and the second coating layer 422, and a transparent conductive layer 424. The active layer 423 serves as a substrate barrier relative to the first coating layer 421 and the second coating layer 422. The transparent conductive layer 424 is made of transparent and conductive metal oxide. For example, the transparent conductive layer 424 is made of indium and tin oxide, and is formed on the second coating layer 422. The electrode unit 43 includes a first electrode 431 on the first coating layer 421 and a second electrode 432 on the transparent conductive layer 424. The first electrode 431 and the second electrode 432 respectively electrically connect with electrical connecting wires (not shown) for supplying power to the light emitting film 42, whereby the LED chip 4 is able to emit light.

When the first electrode 431 and the second electrode 432 supply power to the LED chip 4 through the electrical connecting wires, current flows through the light emitting film 42. The light emitting film 42 then generates light due to electrons/holes recombination. Most light moving upward directly emits toward the outside of the LED chip component. While other light not moving positively is reflected by the reflecting mirror 32 of the heat sink substrate 3, and the reflected light projecting to the reflecting portion 34 is reflected again in a concentrated direction because of the smooth curved surface of the top surface of the reflecting portion 34, and then the light positively emits toward the outside. Therefore, the LED chip component 2 has high luminescence performance. Simultaneously, internal heat resulting from light emitting of the LED chip 4 directly passes through the heat sink substrate 3 to go away from the LED chip 4. Compared to prior art, the LED chip component 2 of the present invention avoids light passing through a connecting portion 13 which is used to glue the LED chip 12 as shown in Fig. 1. As a result, the present invention can dissipate heat more quickly and more effectively, assuring operation of the LED chip 4 stably and efficiently, and therefore enhancing luminescence performance of the LED chip component 2 and extending work duration thereof.

Fig. 3 illustrates a flow chart of a method for manufacturing the LED chip component of Fig. 2, which is interpreted more explicitly below.

Referring to Fig. 3, first, carry out a chip forming step 51 by providing the LED chip 4 including at least one base material 41 for layer growth, the light emitting film 42 on the base material 41, and the electrode unit 43 connecting with and Ohm contacting the light emitting film 42. Notably, the first step is suitable for producing either a single LED chip or multiple isolated LED chips, or for mass production of LED chips by wafer production methods.

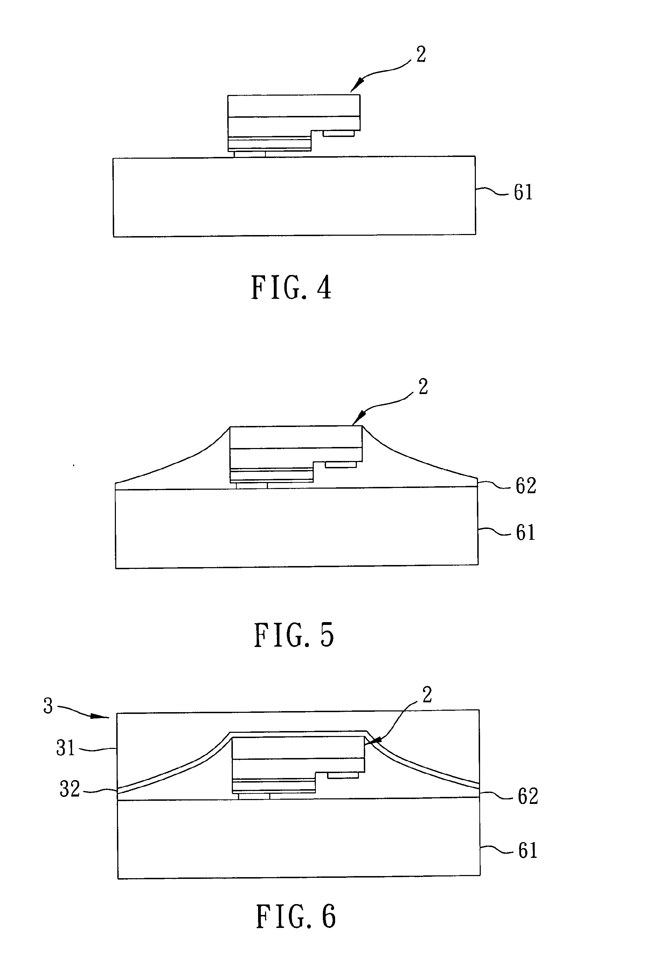

Further referring to Fig. 4, secondly, carry out a chip setting step 52 by turning the LED chip 4 and putting it on a support portion 61 in such a way that the light emitting film 42 facing to the support portion 61. For example, the support portion 61 is a glass base board.

Referring to Figs. 3 and 5, thirdly, carry out a sacrificial layer forming step 53 by putting macromolecule polymer, for example, a sensitive light-resistance material, on the support portion 61 to form a removable sacrificial layer 62 surrounding the LED chip 4 from a top of the LED chip 4 to the support portion 61 such that the sacrificial layer 62 decreases in thickness by means of controlling speed with rotating coating process.

Referring to Figs. 3 and 6, next, carry out a heat sink substrate forming step 54 by forming the reflecting mirror 32 with physically plating film technique from the base material 41 of the LED chip 4 up to the sacrificial layer 62 with material of high light reflectivity coefficient and high thermal conductivity coefficient. Sequentially, high thermal conductivity material is coated on the reflecting mirror 32 and increases in thickness by electroplating to form a base 31. The reflecting mirror 32 and the base 31 cooperatively form a heat sink substrate 3 having a top surface substantially parallel to a bottom surface of the base material 41.

The final step is to carry out a sacrificial layer removing step 55 by etching and removing the sacrificial layer 62 to form the LED chip component with heat sink substrate 2 which has been turned back as well as shown in Fig. 2.

Preferably, in the heat sink substrate forming step 54, the reflecting mirror 32 may be formed with at least two film portions which are arranged in such a way that one of the two film portions of relatively high refractive index is overlapped with another film portion of relatively low refractive index, thereby further improving light reflection. The base 31 may be formed by electroplating (with power or without power) or by vacuum plating.

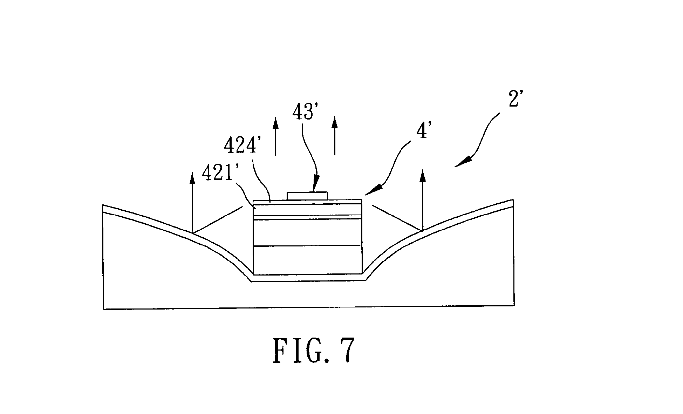

Referring to Fig. 7, according to a second embodiment of the present invention, a LED chip component 2' is similar to the LED chip component 2 of the first embodiment of the present invention except an LED chip 4' of the LED chip component 2'. The LED chip 4' is a vertical conductivity LED chip. So an electrode unit 43', and connection between a transparent conductive layer 424' and a first coasting layer 421' are distinguished from the horizontal conductive LED chip 4 of the first embodiment. The horizontal conductive LED chip 4 and the vertical conductivity LED chip 4' are both well know to the art and are not the vital spirit of the invention. Therefore more detailed description of the LED chip is omitted. The method for manufacturing the LED chip component 2' according to the second embodiment is similar to the method for manufacturing the LED chip component 2 according to the first embodiment except for chip manufacturing step. The method for manufacturing the LED chip component 2 according to the first embodiment produces a horizontal conductive LED chip 4 in the chip manufacturing step, while the method for manufacturing the LED chip component 2' according to the second embodiment produces a vertical conductive LED chip 4' in the chip manufacturing step.

More changes or variation may be made to the present invention without escaping from the spirit of the present invention. For example, a plurality of LED chips 4, 4' are provided on the central portion 33 of the heat sink substrate 3, enhancing luminance of the LED chip component. In another embodiment, the LED chips 4, 4' are of different wavelengths. The LED chip component may emit mixed lights, especially white light. In another embodiment, a plurality of LED chips 4, 4' which emit single light are together provided on one LED chip component, enhancing luminance of the light emitter. In another embodiment, a plurality of LED chips 4, 4' which emit mixer light are together provided on one LED chip component. Such changes all belong to the scope of this invention.

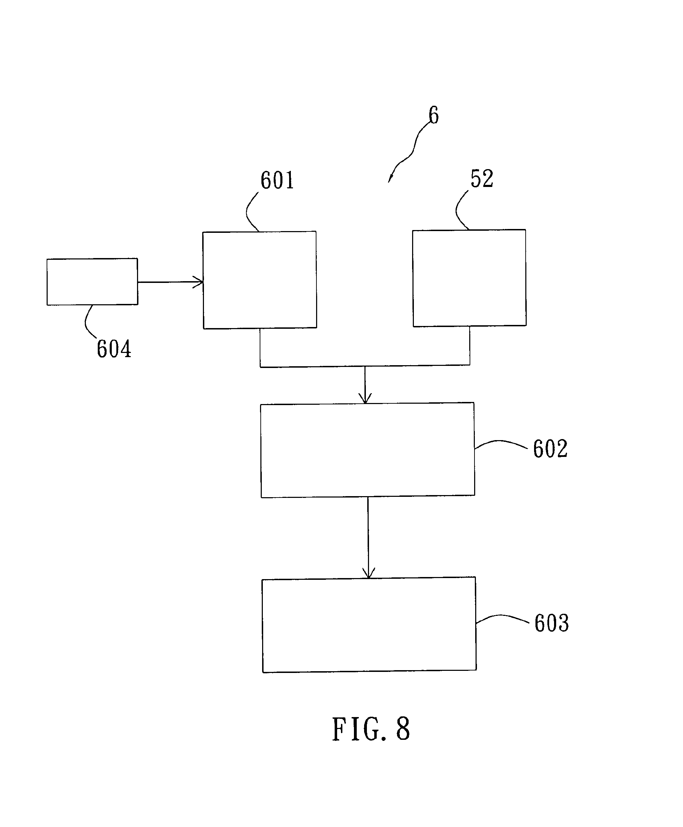

The first electrode 431 and the second electrode 432 of the electrode unit 43 are required to be connected with external circuits so as to emit. A method for packaging the LED chip component 6 described below is able to electrically connect the first electrode 431 and the second electrode 432 of the LED chip 4 respectively to an anode and a cathode of a carrier described below so as to reduce extra processes of preforming connecting points on the first electrode 431 and the second electrode 432 for connecting with the external circuits. Referring to Fig. 8 illustrating a flowchart of the method 6 for packaging the LED chip component of the present invention, the packaging method 6 is further involved in the chip setting step 52 and performed before the LED chip 4 is put and fixed onto the support portion 61. The packaging method 6 includes following steps: an electrode forming step 601, a connecting step 602 and a bonding step 603, wherein the electrode forming step 601 according to the present invention is performed by providing the carrier carrying the anode and the cathode, wherein the anode and the cathode can be formed in various ways. In practice, the carrier can be made of a material which already has the anode and the cathode thereon, or the carrier is additionally formed with the anode and the cathode by a technique of mesh print, micro etching, stamping, integrally molding, adhesion, thermo-compression, ink-jet printing, or laser activation.

The connecting step 602 is performed by connecting the first electrode 431 and the second electrode 432 of the LED chip 4 to the anode and the cathode of the carrier to establish electrical communication by means of Ball Grid Array (BGA) package technique or Surface Mount Technology (SMT), or through general electric wires. The bonding step 603 is defined to bond the carrier with the LED chip 4 firmly by means of constantly press-fitting and heating, or through an adhesive, to firmly join the anode and the cathode of the carrier with the LED chip 4. Notably, the carrier and the LED chip 4 are further dispensed with negative photo-resist (PR) thereon and then exposed to ultraviolet radiation (UV) and developed, still further, the LED chip 4 and the carrier are treated by thin-film deposition and electroplating to form a reflecting layer and a dissipating layer.

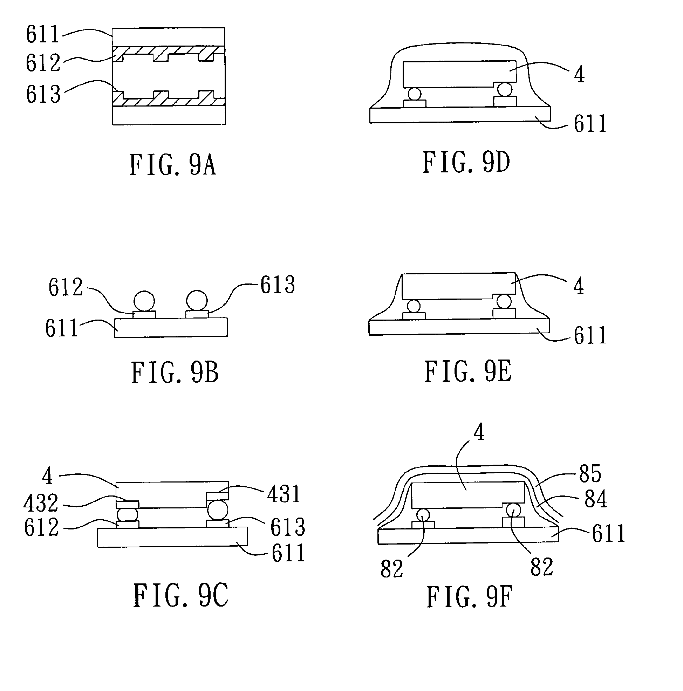

Referring to Figs. 9A to 9F illustrating a first variant of the packaging method 6. In this preferred variant, first, the electrode forming step 601 is performed by providing a carrier 611 etched to form an anode 612 and a cathode 613 (as shown in Figs. 9A and 9B); second, the connecting step 602 is performed by soldering balls 82 on the anode 612 and the cathode 613 by means of the technique of Ball Grid Array (BGA) package (alternatively, the balls are soldered on the LED chip 4) to be electrically connected with the first electrode 431 and the second electrode 432 of the LED chip 4 (as shown in Fig. 9C); next, perform the bonding step 603 by constantly press-fitting and heating the anode 612 and the cathode 613 of the carrier 611 with the LED chip 4 (as shown in Fig. 9D); After the preceding steps, dispense a negative photo-resist (PR) on the carrier 611 and the LED chip 4, then exposed to ultra radiation (UV) and developed to define an exposed upper portion of the LED chip 4 (as shown in Fig. 9E), and then the LED chip 4 and the carrier 611 made of light transmissive material are treated by thin-film deposition and electroplating to form the reflecting layer 84 and the dissipating layer 85, the reflecting layer 84 is of high reflection coefficient and the dissipating layer 85 is of high thermal conductivity for further dissipating heat from the LED chip 4 (as shown in Fig. 9F).

Consequently, the LED chip component 2 packaged by the packaging method 6 as described above further defining the carrier 611 having the anode 612 and the cathode 613, the reflecting layer 84, and the dissipating layer 85, whereby light emitting efficiency is greatly enhanced.

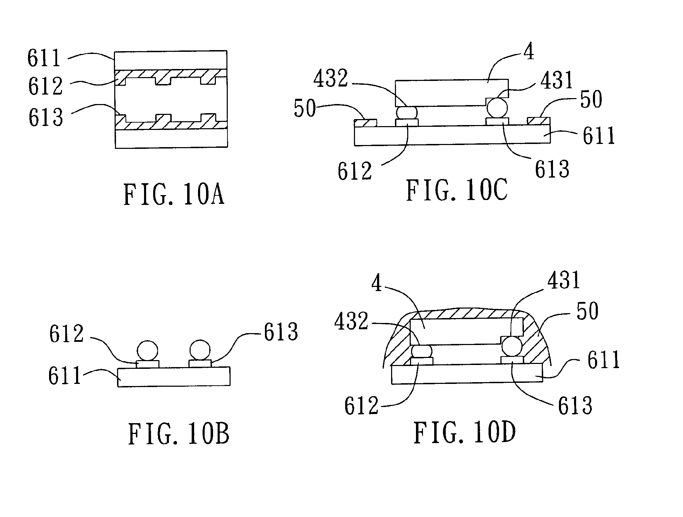

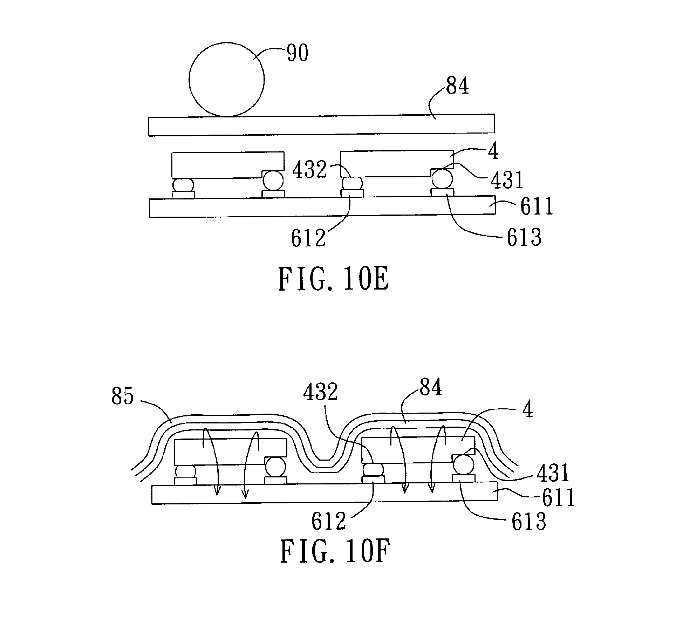

Referring to Figs. 10A to 10F illustrating a second variant of the packaging method 6 of the present invention, as described in the electrode forming step 601, the carrier 611 is formed with the anode 612 and the cathode 613 by the etching technique or other appropriate techniques (as shown in Figs. 10A and 10B); Alternatively, the procedure of forming the anode and the cathode 612, 613 can be omitted when the carrier 611 is made of a material which already has an anode and a cathode thereon. Next to the electrode forming step 601, solder balls 82 on the anode 612 and the cathode 613 of the carrier 611 (alternatively, solder balls 82 on the LED chip 4) by means of BGA package technique to electrically connect with the first electrode 431 and the second electrode 432 of the LED chip 4, which is referred to the connecting step 602 as shown in Fig. 10C; then, bond together the anode 612 and the cathode 613 of the carrier 611 with the LED chip 4 by constantly press-fitting and heating, which is referred to the bonding step 603; moreover, pre-determine adhesive portions on the carrier 611 bonded with the LED chip 4 and partially dispense (or fully dispense) an adhesive 50 on the adhesive portions (as shown in Fig. 10C), the adhesive 50, for example, is a fixing glue (as shown in Fig. 10D); subsequently, the carrier 611 and the LED chip 4 are further pressed together by a soft roller 90 rolling on the reflecting layer 84 and the dissipating layer 85 (as shown in Fig. 10E), or pressed by stamping technique or eutectic bonding technique. Accordingly, the LED chip 4, the carrier 611, the reflecting layer 84, and the dissipating layer 85 are closely bonded to each other, whereby a light cup (not labeled) is formed as shown in Fig. 10F, and the packaging method 6 is completed.

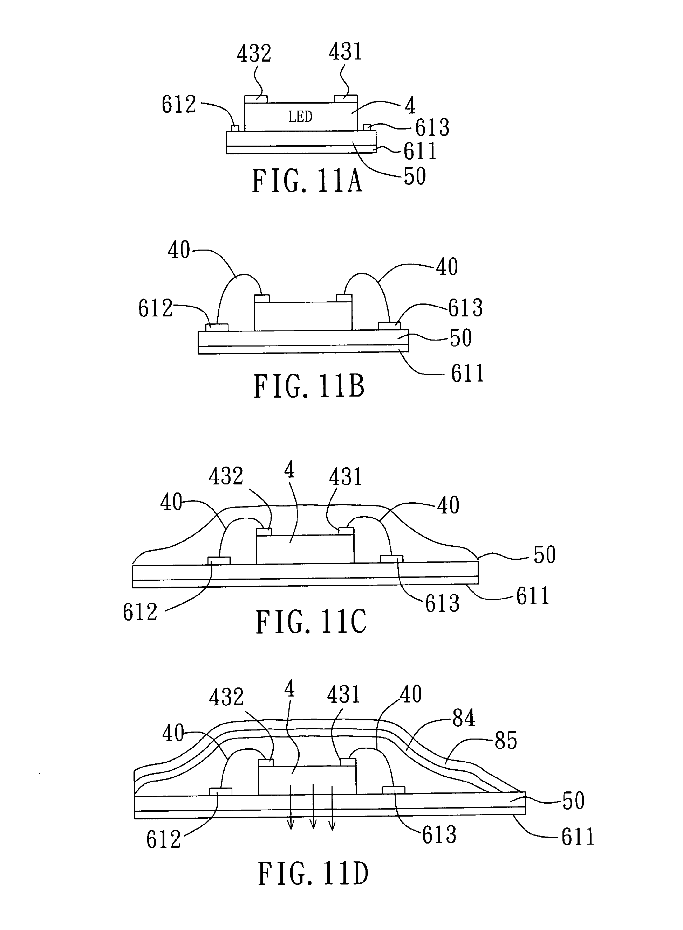

Referring to Figs. 11A to 11D illustrating a third variant of the packaging method 6, in this variant the electrode forming step 601 is performed by the same way as described in the preceding packaging methods while the connecting step 602 and the bonding step 603 are performed by wire bonding with the adhesive 50, that is, the LED chip 4 is reversely mounted on the carrier 611 such that the first electrode 431 and the second electrode 432 are opposite to the carrier 611, wherein the carrier 611 is dispensed with the adhesive 50 (for example, a fixing glue) as shown in Fig. 11A; then connect the anode and the cathode 612, 613 of the carrier 611 Page 13 of 20 with the positive and the negative electrodes 431, 432 of the LED chip 4 with electric wires 40 to establish electrical communication therebetween (as shown in Figs. 11B and 11C); then the carrier 611 and the LED chip 4 are further pressed together by the soft roller 90 rolling on the reflecting layer 84 and the dissipating layer 85 (as shown in Fig. 10E of the second embodiment). Accordingly, the LED chip 4, the carrier 611, the reflecting layer 84, and the dissipating layer 85 are closely bonded to each other, whereby a light cup (not labeled) is formed as shown in Fig. 11D, and the packaging method 6 is completed.

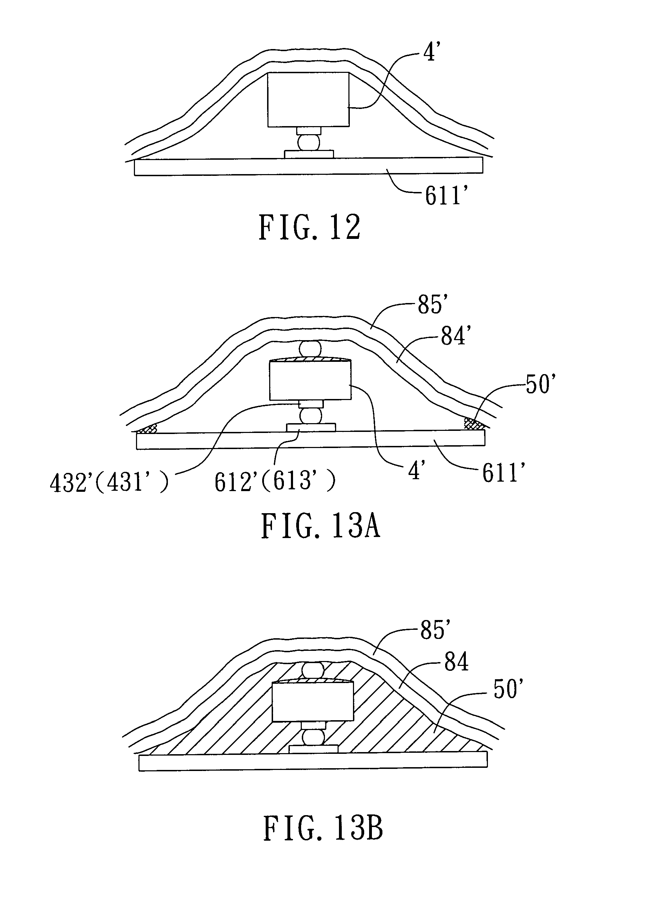

Referring to Figs. 12 and 13A to 13B respectively illustrating fourth, fifth, and sixth variants of the packaging method 6. The packaging method 6 is involved in the chip setting step 52 and performed before the LED chip 4 is put and fixed onto the support portion 61. The main difference between the fourth to sixth variants and the first three variants is that a vertical type LED chip 4' is presented in the fourth to sixth variants, while other features all remain the same as described in the preceding first to third variants.
With reference to Fig. 12, the electrode step 601 and the connecting step 602 are performed in order as described above, then constantly press-fit and heat the carrier 611' with the LED chip 4' as disclosed in the bonding step 603; after the preceding steps 602, 603, dispense a negative photo-resist (PR) on the carrier 611' and the LED chip 4', then the carrier 611' and the LED chip 4' are exposed to ultra radiation (UV) and developed to define an exposed upper portion of the LED chip 4', and the LED chip 4' and the carrier 611' are treated by thin-film deposition and electroplating to form a reflecting layer 84' and a dissipating layer 85'. Accordingly, the packaging method 6 is completed.

Further referring to Fig. 13A illustrating the fifth variant of the packaging method 6, first, the electrode forming step 601 is performed by providing the carrier 611' formed with the anode 612' and cathode 613' by etching technique or other appropriate techniques, then solder balls on the anode 612' and the cathode 613' of the carrier 611' by means of the BGA package technique (alternatively, solder balls on the first electrode 431' and the second electrode 432' of the LED chip 4') to be electrically connected with the first electrode 431' and the second electrode 432 ' of the LED chip 4'. Next, pre-determine adhesive portions on the carrier 611' bonded with the LED chip 4' and partially dispense adhesive 50' thereon (or fully dispense), the adhesive 50', for instance, is a fixing glue (as shown in Fig. 13B); then the carrier 611' and the LED chip 4' are further pressed against each other by the soft roller 90 rolling on the reflecting layer 84' and the dissipating layer 85' (as shown in Fig. 10E). Accordingly, the LED chip 4', the carrier 611', the reflecting layer 84', and the dissipating layer 85' are closely bonded to each other, whereby a light cup (not labeled) is formed as shown in Fig. 13B and the packaging method 6 is completed.

Subsequent to the packaging method 6, the LED chip 4 is put on the support portion 61 and therefore the chip setting step 52 is fulfilled, then the rest of the steps, the sacrificial layer forming step 53, the heat sink substrate forming step 54, and the sacrificial layer removing step 55 are carried out in sequence to manufacture the LED chip component 2 with the heat sink substrate 3.

It is understood that the invention may be embodied in other forms without departing from the scope thereof as defined by the claims.

## Claims

1. A method for manufacturing a LED chip component (2), comprising:
a chip forming step (51) performed by providing a LED chip (4) including a base material (41), a light emitting film (42) on the base material (41) for generating light by photoemission, and an electrode unit (43) connecting with and Ohm contacting the light emitting film (42) for supplying power to the light emitting film (42);
a chip setting step (52), wherein the LED chip (4) is put and fixed onto a mounting surface of a temporary carrier substrate (61) in such a way that a light emitting plane of the LED chip (4) is facing the mounting surface of the temporary carrier substrate (61),
a sacrificial layer forming step (53) performed by forming a removable sacrificial layer (62) on the mounting surface of the temporary carrier substrate (61) and surrounding peripheral surfaces of the LED chip (4) such that a thickness of the sacrificial layer (62) in a direction normal to the mounting surface of the temporary carrier substrate (61) decreases with increasing distance along the mounting surface of the carrier substrate from the LED chip (4), forming a smooth concave surface of the sacrificial layer (62);
a heat sink substrate forming step (54) performed by providing a heat sink substrate (3) made of a material of high thermal conductivity coefficient disposed on and conforming to the smooth concave surface of the sacrificial layer (62), the heat sink substrate (3) having a top surface substantially parallel to a bottom surface of the base material (41); and
a sacrificial layer removing step (55) performed by removing the sacrificial layer (62) and the temporary carrier substrate (61) to form the LED chip component (2) with heat sink substrate (3).

2. The method of claim 1, wherein the heat sink substrate forming step (54) comprises forming a reflecting mirror (32) from a bottom of the base material (41) of the LED chip (4) to the sacrificial layer (62) with material of high light reflectivity coefficient, sequentially forming a base (31) coated incrementally upward on the reflecting mirror (32) with high thermal conductivity material, the reflecting mirror (32) and the base (31) cooperatively forming the heat sink substrate (3).

3. The method of claim 2, wherein the reflecting mirror (32) is formed with at least two film portions which are arranged in such a way that a film portion of relatively high refractive index is overlapped with a film portion of relatively low refractive index, wherein the reflecting mirror (32) is gold, silver, nickel, chromium, or a material combined with either of said elements, and the heat sink substrate is made of copper, gold, silver, nickel, tin, titanium, platina, palladium, tungsten, molybdenum, graphite, or a material combined with either of said elements.

4. The method of claim 2, wherein the base (31) is formed incrementally by electroplating.

5. The method of claim 1, wherein the chip setting step (52) further comprises a packaging method (6) performed before the LED chip (4) being put and fixed onto the support portion (61) for packaging the LED chip (4), the packaging method (6) including an electrode forming step (601), a connecting step (602), and a bonding step (603), wherein
the electrode forming step (601) defined by providing a carrier (611) formed with an anode (612) and a cathode (613);
the connecting step (602) performed by electrically connecting the anode (612) and the cathode (613) of the carrier (611) with the electrode unit (43) of the LED chip (4); and
the bonding step (603) defined to further bond the carrier (611) with the LED chip (4) firmly.

6. The method of claim 5, wherein the anode (612) and the cathode (613) of the carrier (611) are formed by a technique of mesh print, micro etching, stamping, integrally molding, adhesion, thermo-compression, ink-jet printing, or laser activation.

7. The method of claim 5, wherein the carrier and the LED chip (4) are further dispensed with negative photo-resist (PR) thereon, then exposed to ultraviolet radiation (UV) and developed, and treated by thin-film deposition and electroplating to form a reflecting layer (84) and a dissipating layer (85).

8. The method of claim 5, wherein the carrier (611) is made of a material having the anode and the cathode.

9. The method of claim 5, wherein the anode (612) and the cathode (613) of the carrier (611) electrically connect with the electrode unit (43) of the LED chip (4) by means of Ball Grid Array (BGA) package technique, Surface Mount Technology (SMT) technique, or wire bonding technique.

10. The method of claim 5, wherein the bonding step (603) is performed by constantly press-fitting and heating or through an adhesive (50) to firmly join the anode (612) and the cathode (613) of the carrier (611) with the LED chip (4).

11. The method of claim 7, wherein the LED chip (4) and the carrier (611) are further pressed by a soft roller (90) rolling on the reflecting layer (84) and the dissipating layer (85), or by stamping, or eutectic bonding to firmly bond the LED chip (4), the substrate (3), the reflecting layer (84), and the dissipating layer (85) so as to form a light cup for concentrating light.

## Patentansprüche

1. Ein Verfahren zum Herstellen eines LED-Chip-Bauteils (2), aufweisend:
einen Chip-Bildungsschritt (51), der durch Bereitstellen eines LED-Chips (4) durchgeführt wird, der aufweist: ein Basismaterial (41), einen lichtemittierenden Film (42) auf dem Basismaterial (41) zum Erzeugen von Licht mittels Fotoemission, und eine Elektrodeneinheit (43), die mit dem lichtemittierenden Film (42) verbunden ist und diesen Ohm-kontaktiert, zum Versorgen des lichtemittierenden Films (42) mit Strom,
einen Chip-Setz-Schritt (52), wobei der LED-Chip (4) derart auf eine Montagefläche eines temporären Trägersubstrats (61) gesetzt und darauf fixiert wird, dass eine lichtemittierende Ebene des LED-Chips (4) der Montagefläche des temporären Trägersubstrats (61) zugewandt ist,
einen Opferschicht-Bildungsschritt (53), der durch Bilden einer lösbaren Opferschicht (62) auf der Montagefläche des temporären Trägersubstrats (61) und Umgeben von Umfangsflächen des LED-Chips (4) durchgeführt wird, so dass eine Dicke der Opferschicht (62) in einer Richtung senkrecht zu der Montagefläche des temporären Trägersubstrats (61) mit zunehmendem Abstand von dem LED-Chip (4) entlang der Montagefläche des Trägersubstrats kleiner wird, wobei eine glatte konkave Fläche der Opferschicht (62) ausgebildet wird,
einen Wärmesenkensubstrat-Bildungsschritt (54), der durch Bereitstellen eines Wärmesenkensubstrats (3) durchgeführt wird, das aus einem Material mit einem hohen Wärmeleitfähigkeitskoeffizienten hergestellt wird, das auf der glatten konkaven Fläche der Opferschicht (62) angeordnet und an diese angepasst wird, wobei das Wärmesenkensubstrat (3) eine obere Fläche hat, die im Wesentlichen parallel zu einer unteren Fläche des Basismaterials (41) ist, und
einen Opferschicht-Entfernungsschritt (55), der durch Entfernen der Opferschicht (62) und des temporären Trägersubstrats (61) durchgeführt wird, um das LED-Chip-Bauteil (2) mit dem Wärmesenkensubstrat (3) auszubilden.

2. Das Verfahren gemäß Anspruch 1, wobei der Wärmesenkensubstrat-Bildungsschritt (54) aufweist: Ausbilden eines reflektierenden Spiegels (32) von einem Boden des Basismaterials (41) des LED-Chips (4) zu der Opferschicht (62) mit einem Material mit einem hohen Lichtreflexionskoeffizienten, sequentielles Bilden einer Basis (31), die an dem reflektierenden Spiegel (32) inkrementell nach oben mit einem hochwärmeleitfähigen Material beschichtet wird, wobei der reflektierende Spiegel (32) und die Basis (31) zusammenwirkend das Wärmesenkensubstrat (3) ausbilden.

3. Das Verfahren gemäß Anspruch 2, wobei der reflektierende Spiegel (32) mit mindestens zwei Filmabschnitten ausgebildet wird, die derart angeordnet sind, dass ein Filmabschnitt mit einem relativ hohen Brechungsindex mit einem Filmabschnitt mit einem relativ geringen Brechungsindex überlappt ist, wobei der reflektierende Spiegel (32) Gold, Silber, Nickel, Chrom oder ein Material kombiniert mit irgendeinem dieser Elemente ist, und das Wärmesenkensubstrat aus Kupfer, Gold, Silber, Nickel, Zinn, Titan, Platin, Palladium, Wolfram, Molybdän, Graphit oder einem mit irgendeinem dieser Elemente kombiniertem Material hergestellt ist.

4. Das Verfahren gemäß Anspruch 2, wobei die Basis (31) inkrementell durch Galvanisieren gebildet wird.

5. Das Verfahren gemäß Anspruch 1, wobei der Chip-Setz-Schritt (52) ferner ein Verpackungsverfahren (6) aufweist, das durchgeführt wird, bevor der LED-Chip (4) auf den Trägerabschnitt (61) gesetzt und darauf fixiert wird, zum Verpacken des LED-Chips (4), wobei das Verpackungsverfahren (6) einen Elektroden-Bildungsschritt (601), einen Verbindungsschritt (602) und einen Bondingschritt (603) aufweist, wobei:
der Elektroden-Bildungsschritt (601) durch Bereitstellen eines Trägers (611) definiert wird, der mit einer Anode (612) und einer Kathode (613) ausgebildet wird,
der Verbindungsschritt (602) durch elektrisches Verbinden der Anode (612) und der Kathode (613) des Trägers (611) mit der Elektrodeneinheit (43) des LED-Chips (4) durchgeführt wird, und
der Bondingschritt (603) definiert wird, um den Träger (611) ferner fest mit dem LED-Chip (4) zu bonden.

6. Das Verfahren gemäß Anspruch 5, wobei die Anode (612) und die Kathode (613) des Trägers (611) mittels einer Technik des Siebdruckens, des Mikroätzens, des Prägens, des integralen Formens, des Klebens, der Thermokompression, des Tintenstrahldruckens oder der Laseraktivierung gebildet werden.

7. Das Verfahren gemäß Anspruch 5, wobei der Träger und der LED-Chip (4) ferner mit Negativ-Fotolack (PR) darauf dispensiert werden, dann einer ultravioletten Strahlung (UV) ausgesetzt und entwickelt werden, und durch Dünnfilmabscheidung und Galvanisierung behandelt werden, um eine Reflexionsschicht (84) und eine Ableitungsschicht (85) auszubilden.

8. Das Verfahren gemäß Anspruch 5, wobei der Träger (611) aus einem Material hergestellt wird, das die Anode und die Kathode aufweist.

9. Das Verfahren gemäß Anspruch 5, wobei die Anode (612) und die Kathode (613) des Trägers (611) mittels einer Kugelgitterarray- (BGA) -Verpackungstechnik, einer Oberflächenmontiertechnologie- (SMT) -Technik oder einer Drahtbondingtechnik elektrisch mit der Elektrodeneinheit (43) des LED-Chips (4) verbunden werden.

10. Das Verfahren gemäß Anspruch 5, wobei der Bondingschritt (603) durch konstantes Einpressen und Erwärmen oder mittels eines Klebstoffs (50) durchgeführt wird, um die Anode (612) und die Kathode (613) des Trägers (611) fest mit dem LED-Chip (4) zu verbinden.

11. Das Verfahren gemäß Anspruch 7, wobei der LED-Chip (4) und der Träger (611) durch eine weiche Walze (90), die auf der Reflexionsschicht (84) und der Ableitungsschicht (85) rollt, oder durch Prägen oder durch eutektisches Bonden weiter gepresst werden, um den LED-Chip (4), das Substrat (3), die Reflexionsschicht (84) und die Ableitungsschicht (85) fest zu bonden, um eine Lichtschale zum Konzentrieren von Licht auszubilden.

## Revendications

1. Procédé destiné à fabriquer un composant de puce de LED (2), comprenant :
une étape de formation de puce (51) exécutée en fournissant une puce de LED (4) qui comprend un matériau de base (41), un film luminescent (42) situé sur le matériau de base (41) destiné à générer une lumière par photoémission, et une unité électrodes (43) qui est connectée par contact ohmique au film luminescent (42) et qui est destinée à alimenter le film luminescent (42) ;
une étape de placement de puce (52), dans laquelle la puce de LED (4) est placée et fixée sur une surface de montage d'un substrat porteur provisoire (61) de telle manière que le plan luminescent de la puce de LED (4) fasse face à la surface de montage du substrat porteur provisoire (61) ;
une étape de formation d'une couche martyre (53) exécutée en formant une couche martyre qui peut être éliminée (62), sur la surface de montage du substrat porteur provisoire (61) et qui entoure les surfaces périphériques de la puce de LED (4) de telle sorte que l'épaisseur de la couche martyre (62), dans une direction normale à la surface de montage du substrat porteur provisoire (61), diminue à mesure que la distance augmente le long de la surface de montage du substrat porteur à partir de la puce de LED (4), en formant une surface concave douce de la couche martyre (62) ;
une étape de formation d'un substrat dissipateur thermique (54) exécutée en fournissant un substrat dissipateur thermique (3) réalisé dans un matériau qui présente un coefficient de conductivité thermique élevé disposé sur la surface concave douce de la couche martyre (62) et qui se conforme à celle-ci, le substrat dissipateur thermique (3) présentant une surface supérieure sensiblement parallèle à la surface inférieure du matériau de base (41) ; et
une étape d'élimination de la couche martyre (55) exécutée en éliminant la couche martyre (62) et le substrat porteur provisoire (61) de façon à former le composant de puce de LED (2) avec le substrat dissipateur thermique (3).

2. Procédé selon la revendication 1, dans lequel l'étape de formation du substrat dissipateur thermique (54) comprend une étape consistant à former un miroir réfléchissant (32) à partir du fond du matériau de base (41) de la puce de LED (4) jusqu'à la couche martyre (62), avec un matériau qui présente un coefficient de réflexion de la lumière élevé, en formant de manière séquentielle une base (31) enduite, sur le miroir réfléchissant (32) de manière incrémentale vers le haut, du produit qui présente une conductivité thermique élevée, le miroir réfléchissant (32) et la base (31) formant en coopération le substrat dissipateur thermique (3).

3. Procédé selon la revendication 2, dans lequel le miroir réfléchissant (32) est formé avec deux parties de film au moins qui sont agencées de telle manière qu'une partie de film qui présente un indice de réfraction relativement élevé, soit recouverte avec une partie de film qui présente un indice de réfraction relativement faible, dans lequel le miroir réfléchissant (32) est réalisé en or, en argent, en nickel, en chrome, ou dans un matériau combiné avec l'un quelconque desdits éléments, et le substrat dissipateur thermique est réalisé en cuivre, en or, en argent, en nickel, en étain, en titane, en platine, en palladium, en tungstène, en molybdène, en graphite, ou dans un matériau combiné avec l'un quelconque desdits éléments.

4. Procédé selon la revendication 2, dans lequel la base (31) est formée de manière incrémentale par placage par galvanoplastie.

5. Procédé selon la revendication 1, dans lequel la phase de placement de puce (52) comprend en outre un procédé de mise en boîtier (6) exécutée avant que la puce de LED (4) ne soit placée et fixée sur la partie support (61), destiné à mettre en boîtier la puce de LED (4), le procédé de mise en boîtier (6) comprenant une étape de formation d'électrode (601), une étape de connexion (602), et une étape de collage (603), dans lequel :
l'étape de formation d'électrode (601) est définie en fournissant un porteur (611) formé avec une anode (612) et une cathode (613) ;
l'étape de connexion (602) est exécutée en connectant de manière électrique l'anode (612) et la cathode (613) du porteur (611) à l'unité électrodes (43) de la puce de LED (4) ; et
l'étape de collage (603) est définie de façon à coller en outre de manière solide le porteur (611) et la puce de LED (4).

6. Procédé selon la revendication 5, dans lequel l'anode (612) et la cathode (613) du porteur (611) sont formées en faisant appel à une technique d'impression sérigraphique, de microgravure, d'estampage, de moulage d'une pièce, d'adhésion, de thermocompression, d'impression à jet d'encre, ou d'activation par laser.

7. Procédé selon la revendication 5, dans lequel le porteur et la puce de LED (4) reçoivent en outre sur ceux-ci un vernis photosensible négatif (PR), et sont ensuite exposés à un rayonnement ultraviolet (UV) puis développés, et traités par un dépôt en couche mince et par placage par galvanoplastie de façon à former une couche réfléchissante (84) et une couche de dissipation (85).

8. Procédé selon la revendication 5, dans lequel le porteur (611) est réalisé dans un matériau qui comprend l'anode et la cathode.

9. Procédé selon la revendication 5, dans lequel l'anode (612) et la cathode (613) du porteur (611) sont connectées de manière électrique à l'unité électrodes (43) de la puce de LED (4) au moyen d'une technique de boîtier matriciel à billes (BGA), d'une technique de montage en surface (SMT), ou d'une technique de liaison par fils.

10. Procédé selon la revendication 5, dans lequel l'étape de collage (603) est exécutée en ajustant avec serrage et en chauffant en permanence, ou en faisant appel à un adhésif (50), de façon à joindre fermement l'anode (612) et la cathode (613) du porteur (611) à la puce de LED (4).

11. Procédé selon la revendication 7, dans lequel la puce de LED (4) et le porteur (611) sont pressés en outre par un rouleau mou (90) qui roule sur la couche réfléchissante (84) et sur la couche de dissipation (85), ou par estampage, ou par collage eutectique, de façon à coller fermement la puce de LED (4), le substrat (3), la couche réfléchissante (84), et la couche de dissipation (85) de manière à former une cupule de lumière destinée à concentrer la lumière.
